# FASCICULE DE BREVET EUROPEEN

(11) **EP 0 742 591 B1**
(45) Date de publication et mention de la délivrance du brevet: **26.09.2001**
(21) Numéro de dépôt: 96410046.5
(22) Date de dépôt: 06.05.1996
(51) Int. Cl.: H01L 27/02

(54) **Composant de protection complet de circuit d'interface de lignes d'abonnés**
Bauelement für den vollständigen Schutz einer Schnittstellenschaltung von Teilnehmerleitungen
Complete protection component for interface circuit of subscriber lines

(30) Priorité: 12.05.1995 FR 9505877
(43) Date de publication de la demande: 13.11.1996
(73) Titulaire: STMicroelectronics S.A., 94250 Gentilly (FR)
(72) Inventeur: Bernier, Eric, 37390 Mettray (FR)
(74) Mandataire: de Beaumont, Michel

(56) Documents cités:
- EP-A- 0 289 431
- EP-A- 0 388 022
- EP-A- 0 550 198
- EP-A- 0 600 810

## Description

La présente invention concerne les dispositifs de protection des circuits d'interface de lignes d'abonnés (SLIC). Il existe des besoins de protection spécifiques pour les circuits SLIC qui sont connectés à des lignes téléphoniques susceptibles de recevoir des perturbations diverses qui, dans certains cas, peuvent être particulièrement importantes, par exemple par suite de coups de foudre ou de contacts entre une ligne téléphonique et une ligne du réseau électrique.

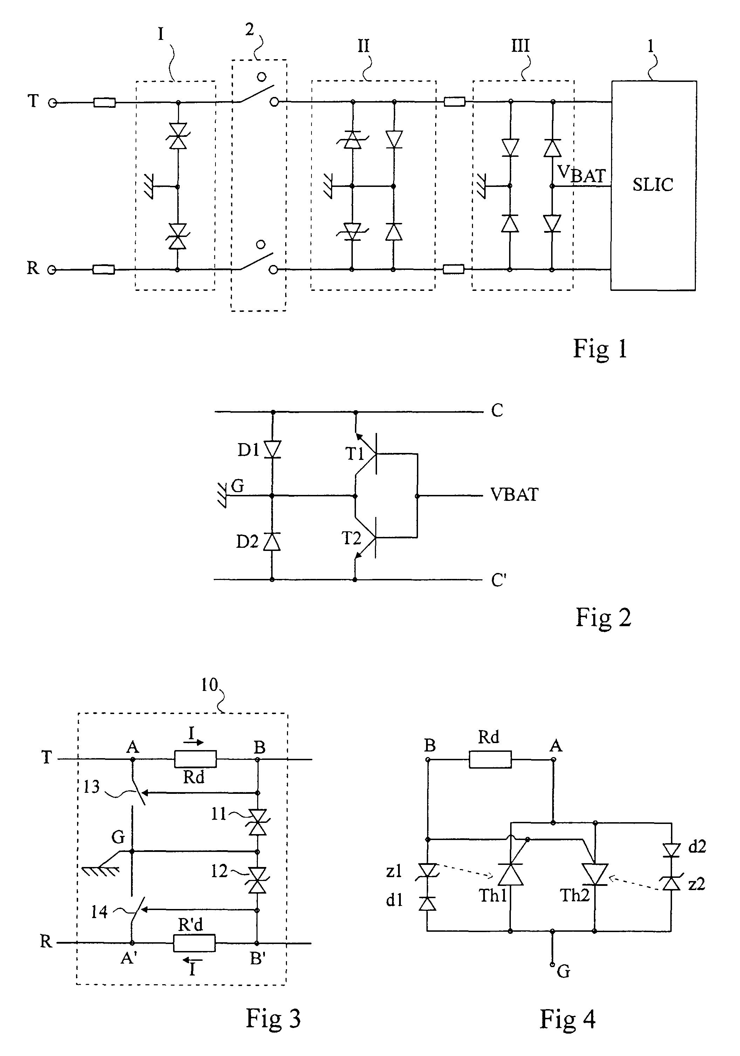

De façon générale, comme le représente la figure 1, les conducteurs T et R d'une ligne téléphonique, habituellement polarisés à des tensions négatives (par exemple -50 et -4 volts, respectivement) sont reliés à l'entrée d'un circuit d'interface d'abonné par l'intermédiaire de relais de prise de ligne 2. Le circuit SLIC comprend divers circuits intégrés et est particulièrement sensible à l'apparition de surcharges électriques. Ainsi, dans la technique, on a développé de très nombreux modes de protection des circuits SLIC.

On utilise généralement séparément ou en combinaison des dispositifs de protection tels que ceux illustrés dans les blocs I, II et III de la figure 1.

Le dispositif de protection I est disposé en amont des relais de prise de ligne 2. Ce dispositif intervient quand les relais de prise de ligne sont en mode sonnerie et doit laisser passer des signaux de sonnerie relativement intenses. Pour cette raison, on trouve généralement dans ce dispositif des protections fixes de type bidirectionnel réglées à des valeurs de l'ordre de 250 volts avec une tenue en surcharge supérieure à 30 ampères pour une onde de surcharge normalisée 10/1000 microsecondes.

Le dispositif de protection II est disposé entre les relais de prise de ligne et le circuit SLIC et n'est susceptible d'intervenir qu'une fois que la ligne est prise, c'est-à-dire quand les relais sont en mode parole. Le niveau de protection est généralement réglé entre 50 et 80 volts. Ce composant doit aussi supporter de fortes surcharges telles que celles résultant d'un coup de foudre ou d'un contact avec une ligne électrique.

On a représenté dans les blocs I et II des exemples classiques de dispositifs de protection utilisés. On notera que ces dispositifs sont susceptibles de nombreuses variantes et modifications. De toute manière, ces dispositifs I et II en raison du fait qu'ils doivent être capables d'absorber de très fortes surcharges ne peuvent pas, actuellement et à des coûts raisonnables, atteindre les caractéristiques de rapidité de réponse recherchées pour les circuits SLIC à circuits intégrés actuels.

En conséquence, on prévoit généralement un troisième niveau de protection rapprochée, le dispositif III de la figure 1, disposé au voisinage immédiat des entrées du circuit SLIC qui doit être extrêmement rapide. Ceci est rendu possible du fait que ce dispositif n'est pas appelé à absorber des surcharges importantes mais seulement à absorber la partie initiale de montée rapide d'une surcharge. En effet, dès qu'un dispositif III entre en action, la résistance disposée en série avec la ligne avant ce dispositif III fait monter la tension de ligne et l'un des dispositifs I et II se déclenche. De façon générale, on estime que le dispositif III doit absorber seulement des intensités de l'ordre de quelques dizaines d'ampères pendant une durée inférieure à 20 microsecondes.

Un mode de réalisation d'un tel dispositif de protection rapprochée est illustré dans le bloc III de la figure 1. Il comprend simplement deux diodes dont les anodes sont connectées aux conducteurs de la ligne et dont les cathodes sont connectées ensemble à la masse et deux diodes dont les cathodes sont reliées aux conducteurs de la ligne et dont l'anode commune est reliée à la tension de batterie disponible à partir du circuit SLIC. Chacune de ces diodes est destinée à fonctionner en direct et l'on cherche à faire des diodes très rapides, à faible surtension à la mise en conduction (faible peak-on). Si une surtension positive apparaît sur l'une des lignes T et R (qui rappelons-le sont normalement polarisées négativement), elle sera éliminée par les diodes connectées à la masse. Si une surtension plus négative que la tension de batterie apparaît sur l'une des lignes, elle sera déchargée vers la tension de batterie V_{BAT} (habituellement une tension négative de l'ordre de -48 volts).

On ne connaît pas actuellement de dispositif équivalent au dispositif de protection rapprochée illustré dans le bloc III de la figure 1 et réalisé sous forme de composant monolithique sur un substrat semiconducteur unique. En effet, on voit que, dans ce circuit, il y a deux diodes connectées par leurs anodes et deux autres diodes connectées par leurs cathodes ce qui conduirait inévitablement à réaliser un circuit monolithique sous forme d'une combinaison de diodes verticales et de diodes latérales, ce qui nuirait à la rapidité du dispositif. A fortiori, on ne connait pas de composant monolithique assurant toutes les fonctions de protection susmentionnées.

La présente invention vise à réaliser sous forme de circuit monolithique tous les dispositifs de protection d'un circuit SLIC sans nuire aux caractéristiques de ces dispositifs.

Pour atteindre cet objet, la demanderesse a commencé par analyser divers dispositifs pouvant réaliser les fonctions remplies par les dispositifs de protection I, II et III de la figure 1.

Parmi ces dispositifs, elle a sélectionné pour assurer la fonction du bloc III de la figure 1 le dispositif qui sera décrit ci-après en relation avec la figure 2 et pour assurer la fonction des blocs I et II de la figure 1, le dispositif qui sera décrit ci-après en relation avec les figures 3 et 4, puis elle a réalisé une intégration monolithique de ces dispositifs.

Ainsi, la présente invention prévoit de sélectionner deux systèmes de protection particuliers et de les combiner pour permettre de réaliser un composant monolithique rassemblant toutes les fonctions de protection utiles à un circuit d'interface de ligne d'abonné. Plus particulièrement, la présente invention propose d'utiliser un premier circuit de protection disposé à l'emplacement du bloc I, combinant une protection en courant et une protection en tension et évitant ainsi l'utilisation du bloc II, avec un circuit de protection rapprochée III particulier tel qu'illustré ci-après en figure 2.

Plus particulièrement, la présente invention prévoit un composant monolithique de protection d'un circuit d'interface de lignes d'abonné comprenant, dans un substrat de type N dont la face arrière est revêtue d'une première métallisation uniforme, deux portions séparées par un mur d'isolement de type P, dans lesquelles la première portion comprend deux diodes verticales à cathode commune correspondant à la face arrière du substrat, deux transistors verticaux à collecteur et base commune, les collecteurs correspondant à la face arrière du substrat ; et la deuxième portion comprend deux ensembles comportant chacun une paire de thyristors verticaux tête-bêche et une paire de diodes zener verticales tête-bêche de commande de mise en conduction de ces thyristors.

Selon un mode de réalisation de la présente invention, la première portion comprend un substrat semiconducteur de type N faiblement dopé dont la face arrière comprend une couche fortement dopée revêtue d'une première métallisation, du côté de la face supérieure du substrat, des premier et deuxième caissons fortement dopés de type P, un troisième caisson de type P faiblement dopé dans lequel sont formées des première et deuxième régions de type N et une région de type P, une deuxième métallisation reliant le premier caisson à la première région de type N, une troisième métallisation reliant le deuxième caisson à la deuxième région de type N, une quatrième métallisation solidaire de la région de type P.

Selon un mode de réalisation de la présente invention, chacun des caissons est entouré d'un anneau de type N.

Selon un mode de réalisation de la présente invention, la deuxième portion comprend des première et deuxième métallisations de face supérieure destinées à être connectées aux bornes d'une résistance ; des premier et deuxième thyristors formés tête-bêche entre les première et troisième métallisations, la deuxième métallisation correspondant à la gâchette de ces thyristors ; et une première diode à avalanche d'une première polarité entre les deuxième et troisième métallisations, et une deuxième diode à avalanche de polarité inverse entre l'une des première et deuxième métallisations et la troisième métallisation, ces première et deuxième diodes étant disposées pour que la mise en conduction de l'une d'entre elles provoque la mise en conduction de l'un des thyristors.

Selon un mode de réalisation de la présente invention, la deuxième portion comprend un substrat du premier type de conductivité ; une première région du deuxième type de conductivité formée dans la surface supérieure du substrat ; une deuxième région du deuxième type de conductivité formée dans la surface inférieure du substrat ; une troisième région du premier type de conductivité formée dans sensiblement la moitié de la surface de la première région ; une quatrième région du premier type de conductivité formée dans sensiblement la moitié de la surface de la deuxième région et sensiblement complémentaire de la troisième région ; une cinquième région du premier type de conductivité formée dans une portion de la première région au-dessus d'une portion de la quatrième région ; une sixième région du premier type de conductivité à fort niveau de dopage formée à l'interface entre la première région et le substrat ; une septième région du premier type de conductivité à fort niveau de dopage formée à l'interface entre la deuxième région et le substrat en regard d'au moins une partie de la quatrième région ; une première métallisation recouvrant la troisième région et la plus grande partie de la première région ; une deuxième métallisation recouvrant une portion de la première région au voisinage de la troisième région et la cinquième région ; et une troisième métallisation recouvrant les deuxième et quatrième régions.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :
la figure 1 représente un schéma d'ensemble de protection d'un circuit d'interface de ligne d'abonné (SLIC) ;
la figure 2 représente sous forme de circuit un type particulier de dispositif de protection rapprochée d'un SLIC ;
la figure 3 représente un schéma sous forme de blocs d'un dispositif de protection d'interface de ligne d'abonné incorporant les fonctions des blocs I et II de la figure 1 ;
la figure 4 illustre sous forme de circuit un mode de réalisation d'un demi-circuit de la figure 3 ; et
la figure 5 représente en coupe une moitié d'un composant semiconducteur monolithique selon la présente invention réalisant l'ensemble des fonctions de protection d'un circuit SLIC.

Comme le représente la figure 2, la présente invention propose d'utiliser comme dispositif de protection rapprochée d'un circuit SLIC un dispositif comprenant deux diodes D1, D2 et deux transistors T1, T2. Les diodes sont connectées aux bornes d'entrée C et C' du circuit SLIC par leurs anodes respectives et sont connectées ensemble par leurs cathodes à la masse G. Les transistors, de type NPN, sont reliés par leurs émetteurs respectivement aux bornes C et C'. Les collecteurs des transistors sont interconnectés et reliés à la masse G. Les bases des transistors sont interconnectées et reliées à la tension V_{BAT}.

Un avantage particulier de cette structure est que chacun des transistors se déclenche quand la tension sur son émetteur devient inférieure à la tension négative V_{BAT} mais qu'ensuite le courant de surcharge n'est pas extrait de la tension V_{BAT} mais de la masse. Ainsi, l'appel de courant sur la source de tension V_{BAT} correspondra à l'intensité de la surcharge divisée par le gain des transistors. Ceci est intéressant en pratique car, en fait, la tension V_{BAT} disponible à partir du circuit SLIC est une tension apparaissant aux bornes d'une capacité et que les normes actuelles exigent de minimiser les appels de courant.

Ainsi, la présente invention, après avoir sélectionné le circuit illustré en figure 2, vise à réaliser ce circuit sous forme de composant monolithique tout en gardant les avantages suivants :
- diodes D1 et D2 rapides et à faible peak-on,
- transistors T1 et T2 rapides à la commutation à la fermeture,
- transistors Tl et T2 de gain élevé (50 à 150), pour limiter le courant extrait de la source V_{BAT},
- transistors T1 et T2 à tenue en tension émetteur-base élevée (environ 100 V), pour supporter la tension normale appliquée en inverse,
- transistors T1 et T2 à faible résistance à l'état passant, pour éviter que le composant ne chauffe et ne puisse être détruit par une surtension.

Comme le représentent les figures 3 et 4, la présente invention prévoit d'utiliser, au lieu des dispositifs I et II, un dispositif de protection unique 10 tel que décrit dans la demande de brevet français 94/05925 du 9 mai 1994 au nom de la demanderesse. Ce dispositif 10 assure d'une part une protection contre une surtension, active quand les relais 2 sont ouverts, représentée à titre d'exemple en figure 3 par des doubles diodes de Shockley 11 et 12, et d'autre part une protection contre des surintensités, active quand les relais 2 sont fermés. Le dispositif 10 est placé avant les relais de prise de ligne, comme le bloc I, et est connecté entre des bornes A et B disposées de part et d'autre d'une résistance de détection Rd en série avec le conducteur T et des bornes A' et B' disposées de part et d'autre d'une résistance de détection R'd en série avec le conducteur R. Les surcharges éventuellement présentes sont évacuées vers une borne G reliée par exemple à la masse. Quand une surintensité est détectée, des commutateurs 13 et 14, disposés respectivement entre les bornes A et G et entre les bornes A' et G, sont fermés. De plus, la mise en conduction de l'un ou l'autre des dispositifs de protection 11 et 12 entraîne également immédiatement la fermeture de l'interrupteur 13 ou 14 correspondant. On notera qu'un avantage de la prévision d'un dispositif de protection contre des surintensités est qu'il évite toute apparition de surintensité dans les relais 2 quand ceux-ci sont fermés.

La figure 4 représente sous forme de circuit le schéma équivalent d'une moitié du dispositif de protection 10. Cette figure représente seulement les éléments existant entre les bornes A, B et G, ce dispositif étant dupliqué entre les bornes A', B' et G. On trouve entre les bornes A et B deux thyristors tête-bêche Th1 et Th2 qui sont respectivement un thyristor à gâchette de cathode et un thyristor à gâchette d'anode. Ces gâchettes sont connectées à la borne B. Ainsi, quand un courant circule dans la résistance Rd, une différence de potentiel apparaît entre la gâchette et l'électrode principale correspondante et provoque la mise en conduction de l'un ou l'autre de ces thyristors selon le sens de circulation du courant. Le thyristor de polarité convenable entrera en conduction quand le potentiel sur sa gâchette différera du potentiel sur l'électrode principale correspondante d'une valeur de l'ordre de 0,7 V. On choisira donc la résistance R en fonction de la valeur du courant I pour lequel on veut déclencher le système de protection pour que RI égale environ 0,7 V. Ainsi, pour des courants I de l'ordre de 100 à 200 mA, la résistance R aura une valeur de l'ordre de 6 à 3 ohms.

Des diodes à avalanche z1 et z2 sont disposées entre la masse et l'une des bornes A ou B. Dans une réalisation pratique, comme on le verra ci-après, ces diodes à avalanche z1 et z2 se trouvent respectivement en série avec des diodes d1 et d2 de polarité opposée. Ainsi, par exemple, quand une surtension positive arrive sur les bornes A et B, la diode à avalanche z2 entrera en conduction et quand une surtension négative sera présente sur les bornes A et B, la diode à avalanche z1 entrera en conduction. Les diodes à avalanche sont conçues en relation avec les thyristors Th1 et Th2 pour que le déclenchement de la diode à avalanche z1 provoque la mise en conduction du thyristor Th1 et que le déclenchement de la diode à avalanche z2 provoque la mise en conduction du thyristor Th2. Ainsi, les diodes à avalanche z1 et z2 ne seront pas traversées par des courants importants puisque les surcharges seront évacuées par les thyristors Th1 et Th2. Les diodes à avalanche z1 et z2 pourront donc être de petite dimension.

La présente invention propose un composant ayant des métallisations correspondant aux bornes A, A', B, B', C, C', G et V_{BAT} et intégrant sous forme monolithique les composants élémentaires illustrés en figures 2 et 3-4.

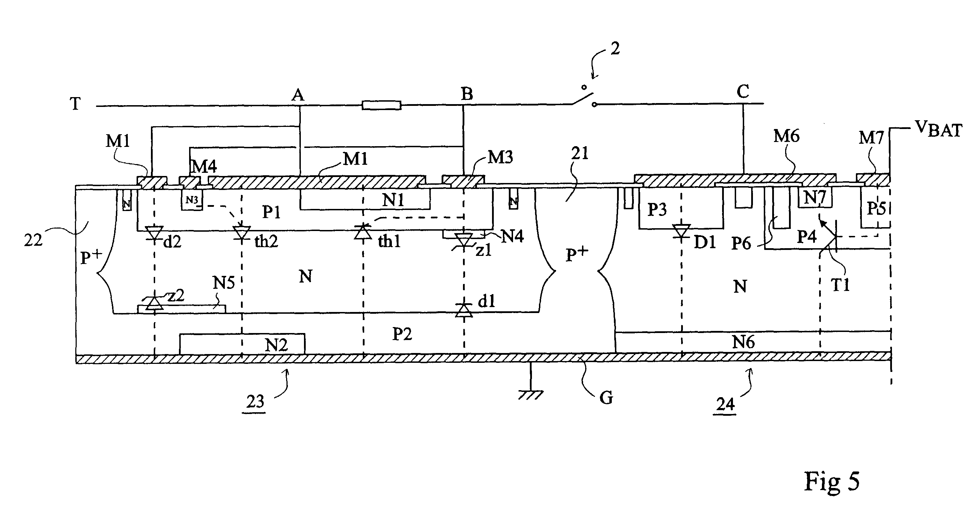

La figure 5 représente une vue en coupe schématique d'une moitié d'un composant selon l'invention. Conformément à l'usage dans le domaine de la représentation des composants semiconducteurs, les épaisseurs et dimensions des diverses couches et régions semiconductrices ne sont pas tracées à l'échelle. On a indiqué sur la figure 5 les positions approximatives des divers composants élémentaires pour permettre de faire la relation avec les circuits illustrés en figures 2-4.

Le composant selon la présente invention est formé à partir d'un substrat d'un premier type de conductivité qui sera ci-après considéré comme étant le type N. Une métallisation unique G recouvre la face arrière. Le composant est divisé en deux portions 23 et 24 par un mur d'isolement 21 de type P et est de préférence entouré d'un mur d'isolement 22. La portion 24 est de préférence centrale.

On va d'abord décrire la portion 23 de la figure 5.

Dans la face supérieure du substrat est formé un caisson P1 de type P et dans la face inférieure est formée une couche P2 de type P. Une région de type N, Ni, est formée dans sensiblement la moitié de la surface du caisson P1 et une région de type N, N2, est formée dans sensiblement la moitié de la surface de la couche P2, de façon sensiblement complémentaire. De plus, une région de type N distincte, N3, est formée dans la région P1 en regard d'une portion de la région N2 formée dans la face opposée. Une région de type N à niveau de dopage élevé, N4, est formée à l'interface entre la région P1 et le substrat N sensiblement sous la région de contact de gâchette du thyristor Th1 correspondant aux régions N1-P1-N-P2. Une région de type N à fort niveau de dopage, N5, est formée à l'interface entre la région P2 et le substrat N au-dessus d'une partie de la région N2. Une métallisation M1 recouvre la plus grande partie de la surface supérieure des régions Ni et P1. Une métallisation M3 recouvre une petite portion de la région P1, au voisinage de la région Ni et au-dessus de la région N4 susmentionnée. Une métallisation M4 recouvre la région N3. La métallisation M1 est reliée à la borne A et les métallisations M3 et M4 à la borne B.

En dehors des zones où elles reposent sur des régions semiconductrices, les métallisations reposent sur des couches minces isolantes non-référencées (classiquement des couches minces d'oxyde de silicium). De préférence un anneau de type N fortement dopé ayant une fonction d'arrêt de canal est disposé dans le substrat à la périphérie externe du caisson P1.

La portion 23 du composant selon l'invention incorpore les composants élémentaires suivants :
- un thyristor vertical Th1 constitué des couches P2-N-P1-N1 dont l'anode correspond à la métallisation G, la cathode à la métallisation M1 et la gâchette à la métallisation M3 ;
- un thyristor vertical Th2 comprenant les couches P1-N-P2-N2 dont l'anode correspond à la métallisation M1 et la cathode à la métallisation G, c'est-à-dire que ce thyristor Th2 est en anti-parallèle avec le thyristor Th1 (ce thyristor Th2 comprend en outre la région N3 qui constitue sa gâchette d'anode) ;
- une diode à avalanche zl correspondant à la jonction P1-N4, dont l'anode correspond à la métallisation M3 et la cathode à la métallisation G (cette diode à avalanche z1 est en série avec une diode d1 correspondant à la jonction N-P2) ; et
- une diode à avalanche z2 correspondant à la jonction P2-N5, dont l'anode correspond à la métallisation G et la cathode à la métallisation M1 (cette diode à avalanche est en série avec une diode d2 correspondant à la jonction P1-N).

La portion 23 de la figure 5 correspond donc bien au schéma équivalent illustré en figure 4. Des composants élémentaires Th'1, Th'2, z'1, z'2, d'2 connectés aux bornes A' B' et G sont réalisés de la même façon et occupent par exemple une surface symétrique du substrat sans être séparés des éléments susmentionnés par un mur d'isolement.

Le fonctionnement du dispositif est le suivant.

Quand les relais 2 sont ouverts et qu'une surtension négative par rapport à la masse survient sur les bornes A et B, la diode à avalanche z1 entre en avalanche et des porteurs sont générés au voisinage de la jonction P1-N. En conséquence, le thyristor Th1 devient passant et la surtension est évacuée vers la masse par ce thyristor Th1.

Quand les relais 2 sont ouverts et qu'une surtension positive par rapport à la masse survient sur les bornes A et B, la diode à avalanche z2 entre en avalanche. Cette mise en avalanche crée une génération de porteurs au voisinage de la jonction N-P2 du thyristor Th2 et ce thyristor entre à son tour en conduction.

Quand les relais 2 sont fermés et qu'une surintensité négative survient sur la ligne, une tension positive apparaît entre la borne B et la borne A. Quand cette tension atteint environ 0,7 V, un courant de gâchette peut circuler dans la jonction P1-N1 et le thyristor à gâchette de cathode Th1 s'amorce de façon classique.

Quand les relais 2 sont fermés et qu'une surintensité positive survient sur la ligne, un courant positif circule de la borne A à la borne B et un potentiel positif apparaît entre ces bornes. Ainsi, la jonction P1-N3 est polarisée en direct et, dès que l'on atteint la tension de seuil de conduction en direct de la diode P1-N3 (environ 0,7 V), une circulation de courant dans la jonction P1-N3 provoque la génération de porteurs également au voisinage de la jonction P1-N et ceci provoque l'amorçage du thyristor Th2 (P1-N-P2-N2).

On a exposé ci-dessus le fonctionnement général d'un composant selon la présente invention. Il faut en outre qu'il satisfasse à diverses caractéristiques de sensibilité et de symétrie pour remplir convenablement la fonction qu'il doit assumer.

L'amorçage du thyristor Th1 ou Th2 par la diode à avalanche z1 ou z2 ne pose pas de problème particulier. Il suffira de choisir le niveau de dopage des régions N4 et N5 pour obtenir une tension d'avalanche souhaitée, par exemple 250 volts. De plus, en cas de surcharge tandis que les relais sont ouverts, en fin de surcharge, aucune tension n'est présente sur la ligne et celui des thyristors Th1 ou Th2 qui est entré en conduction se désamorce naturellement.

Le problème est plus compliqué en cas d'amorçage par une surintensité. En effet, le dispositif doit satisfaire à trois contraintes.

La première contrainte est que les thyristors doivent s'amorcer pour le passage d'un courant déterminé dans la résistance R, par exemple un courant de l'ordre de 200 milliampères. Pour atteindre ce résultat, il faut que le courant de gâchette susceptible de mettre en conduction les thyristors soit faible devant le courant dans la résistance Rd, par exemple de l'ordre de 20 milliampères. Il en résulte que les thyristors Th1 et Th2 doivent être relativement sensibles.

La deuxième contrainte est que le dispositif doit être aussi symétrique que possible, c'est-à-dire s'amorcer pour sensiblement les mêmes seuils de surintensité positive et négative.

La troisième contrainte se présente en particulier dans le cas où le dispositif est destiné à protéger une ligne téléphonique. Alors, quand les relais sont fermés, il apparaît en permanence une tension de l'ordre de -48 V sur la borne de bague (R) par rapport à la borne G. Il faut donc que le thyristor (Th1 ou Th'1) dont l'anode correspond à la borne G et la cathode à la borne de bague puisse se rebloquer quand une tension de 48 V est présente entre ces bornes. Ceci ne pose pas de problème critique pour le thyristor Th1 ou Th'1 car la résistance Rd se trouve en série avec le thyristor et la contrainte sur le courant de maintien du thyristor est en pratique raisonnable. Par contre, en examinant la figure 5, on voit qu'il existe en outre un thyristor parasite P2-N-P1-N3 dont l'anode correspond à la borne G et la cathode à la borne B. Cette borne B est directement reliée à la tension de -48 V. Il faudra donc que ce thyristor parasite présente un courant de maintien élevé pour ne pas rester conducteur à la fin d'une surcharge.

On a montré dans la demande de brevet français susmentionnée que l'on peut satisfaire à ces trois contraintes par un choix approprié des surfaces des diverses couches, des dispositions des régions de gâchette, et des densités des trous de court-circuit d'émetteur formés à travers les régions Ni et N2. On notera que les moyens utilisés pour satisfaire à ces contraintes sont parfaitement compatibles avec la réalisation de la portion 24 du composant.

On va maintenant décrire la portion 24 de la figure 5.

Dans cette portion 24, la face arrière du substrat N comporte une couche de type N fortement dopée N6. La face supérieure comporte un caisson de type P, P3, relativement fortement dopé et un demi-caisson de type P plus faiblement dopé, P4. Dans ce caisson P4, sont formées une région de type N fortement dopée, N7, et une demi-région de type P fortement dopée, P5.

Sur la face supérieure, une métallisation M6 est en contact avec le caisson P3 et la région N7, et une métallisation M7 est en contact avec la région P5.

Les métallisations G, M6 et M7 sont respectivement destinées à être connectées à la masse, à la borne C, et à la tension négative V_{BAT}. En effet, on trouve entre les métallisations M6 et G une diode D1 dont l'anode correspond au caisson P3 et la cathode au substrat, et un transistor NPN T1 dont l'émetteur correspond à la région N7, la base au caisson P4 et le collecteur au substrat N. La métallisation M7 correspond à la base commune des transistors T1 et T2. Cette portion 24 est dupliquée par rapport à l'axe situé à droite de la figure 5 pour fournir la diode D2 et le transistor T2 ayant une base commune avec le transistor T1.

Bien entendu, la présente invention est susceptible de nombreuses variantes et modifications qui apparaîtront à l'homme de l'art.

Bien que les types de conductivité de toutes les couches puissent être intervertis, on préfèrera la structure illustrée dans laquelle le substrat est de type N pour permettre d'assurer convenablement le compromis entre sensibilité et courant de maintien décrit précédemment.

De préférence, un anneau de type N fortement dopé ayant une fonction d'arrêt de canal est disposé dans le substrat à la périphérie externe des caissons P3 et P4. Egalement, un anneau de type P fortement dopé P6 ayant une fonction d'arrêt de canal est disposé dans la périphérie interne du caisson P4.

Dans ce composant, on choisit le substrat N pour que sa résistivité soit aussi faible que possible de façon à minimiser la surtension à la mise en conduction (peak-on) des diodes D1 et D2 constituées par la jonction P3-N et la structure symétrique. Ceci permet de réaliser par diffusion (ou implantation/ diffusion) un caisson P4 faiblement dopé et donc d'assurer un gain élevé aux transistors NPN.

Le dopage du caisson P4 est par exemple choisi avec une concentration en surface Cₛ de 1 à 5.10¹⁵ atomes/cm³, la profondeur de jonction étant de l'ordre de 30 à 40 micromètres. On obtient alors une tenue en tension émetteur/base (B_{VBE}) de l'ordre de 80 à 150 V tout en ayant un gain élevé (de 50 à 150).

## Revendications

1. Composant monolithique de protection d'un circuit d'interface de lignes d'abonné **caractérisé en ce qu'**il comprend, dans un substrat de type N dont la face arrière est revêtue d'une première métallisation uniforme (G), deux portions séparées par un mur d'isolement de type P, dans lesquelles :
la première portion (24) comprend deux diodes verticales à cathode commune correspondant à la face arrière du substrat, deux transistors verticaux à collecteur et base commune, les collecteurs correspondant à la face arrière du substrat, et
la deuxième portion (23) comprend deux ensembles comportant chacun une paire de thyristors verticaux tête-bêche et une paire de diodes zener verticales tête-bêche de commande de mise en conduction de ces thyristors.

2. Composant selon la revendication 1, **caractérisé en ce que** la première portion comprend :
- un substrat semiconducteur de type N faiblement dopé dont la face arrière comprend une couche (N6) fortement dopée revêtue d'une première métallisation (G),
- du côté de la face supérieure du substrat, des premier et deuxième caissons (P3) fortement dopés de type P,
- un troisième caisson (P4) de type P faiblement dopé dans lequel sont formées des première et deuxième régions (N7) de type N et une région (P5) de type P,
- une deuxième métallisation (M6) reliant le premier caisson à la première région de type N,
- une troisième métallisation reliant le deuxième caisson à la deuxième région de type N,
- une quatrième métallisation (M7) solidaire de la région (P5) de type P.

3. Composant selon la revendication 2, **caractérisé en ce que** chacun des caissons est entouré d'un anneau de type N.

4. Composant selon la revendication 1, **caractérisé en ce que** la deuxième portion (24) comprend :
des première et deuxième métallisations de face supérieure (M1, M3-M4) destinées à être connectées aux bornes (A, B) d'une résistance (Rd) ;
des premier et deuxième thyristors (Th1, Th2) formés tête-bêche entre la première métallisation de face supérieure et la métallisation de face arrière (G), la deuxième métallisation correspondant à la gâchette de ces thyristors ; et
une première diode à avalanche (z1) d'une première polarité entre la deuxième métallisation et la métallisation de face arrière (G) et une deuxième diode à avalanche (z2) de polarité inverse entre l'une des première et deuxième métallisations et la métallisation de face arrière (G), ces première et deuxième diodes étant disposées pour que la mise en conduction de l'une d'entre elles provoque la mise en conduction de l'un des thyristors.

5. Composant monolithique de protection selon la revendication 4, comprenant :
un substrat du premier type de conductivité (N) ;
une première région du deuxième type de conductivité (P1) formée dans la surface supérieure du substrat ;
une deuxième région du deuxième type de conductivité (P2) formée dans la surface inférieure du substrat ;
une troisième région du premier type de conductivité (Ni) formée dans sensiblement la moitié de la surface de la première région (P1) ;
une quatrième région du premier type de conductivité (N2) formée dans sensiblement la moitié de la surface de la deuxième région (P2) et sensiblement complémentaire de la troisième région (N1) ;
une cinquième région du premier type de conductivité (N3) formée dans une portion de la première région (P1) au-dessus d'une portion de la quatrième région ;
une sixième région du premier type de conductivité à fort niveau de dopage (N4) formée à l'interface entre la première région (P1) et le substrat ;
une septième région du premier type de conductivité à fort niveau de dopage (N5) formée à l'interface entre la deuxième région (P2) et le substrat (N) en regard d'au moins une partie de la quatrième région (N2) ;
une première métallisation (M1) recouvrant la troisième région (Ni) et la plus grande partie de la première région (P1) ;
une deuxième métallisation (M3, M4) recouvrant une portion de la première région (P1) au voisinage de la troisième région et la cinquième région (N3) ; et
une troisième métallisation recouvrant les deuxième (P2) et quatrième (N2) régions.

## Patentansprüche

1. Monolithisches Schutzbauteil zum Schutz einer Interfaceschaltung einer Teilnehmerleitung, **dadurch gekennzeichnet, daß** das Bauteil in einem Substrat vom N-Typ, dessen Rück- bzw. Unterseite mit einer ersten gleichförmigen Metallisierung (G) überzogen ist, zwei durch eine Isolierwandung vom P-Typ voneinander getrennte Teile aufweist, in welchen
der erste Teil (24) zwei vertikale Dioden mit der Rückseite des Substrats entsprechender gemeinsamer Kathode sowie zwei vertikale Transistoren mit gemeinsamem Kollektor und gemeinsamer Basis umfaßt, wobei die Kollektoren der Rückseite des Substrats entsprechen, und
der zweite Teil (23) zwei Gruppen bzw. Aggregate aufweist, deren jedes ein Paar antiparallel angeordneter vertikaler Thyristoren sowie ein Paar antiparallel angeordneter vertikaler Zenerdioden zur. Einschaltung dieser Thyristoren in den leitenden Zustand umfaßt.

2. Bauteil nach Anspruch 1, **dadurch gekennzeichnet, daß** der erste Bereich umfaßt:
- ein schwach dotiertes Halbleitersubstrat vom N-Typ, dessen Rück- bzw. Unterseite eine mit einer ersten Metallisierung (G) überzogene stark dotierte Schicht (N6) aufweist,
- an der Vorder- bzw. Oberseite des Substrats stark dotierte erste und zweite Gräben (P3) vom P-Typ,
- einen schwach dotierten dritten Graben (P4) vom P-Typ, in welchem erste und zweite Bereiche (N7) vom N-Typ und ein Bereich (P5) vom P-Typ ausgebildet sind,
- eine den ersten Graben mit dem ersten Bereich vom N-Typ verbindende zweite Metallisierung (M6),
- eine den zweiten Graben mit dem ersten Bereich vom N-Typ verbindende dritte Metallisierung,
- eine mit dem Bereich (P5) vom P-Typ fest verbundene vierte Metallisierung (M7).

3. Bauteil nach Anspruch 2, **dadurch gekennzeichnet, daß** jeder Graben jeweils mit einem Ring vom N-Typ umgeben ist.

4. Bauteil nach Anspruch 1, **dadurch gekennzeichnet, daß** der zweite Teil (24) umfaßt:
erste und zweite Metallisierungen (M1, M3-M4) an der Vorder- bzw. Oberseite, die zur Verbindung mit den Anschlüssen (A, B) eines Widerstands (Rd) bestimmt sind;
erste und zweite Thyristoren (Th1, Th2), die in antiparalleler Anordnung zwischen der ersten Metallisierung der Vorder-bzw. Oberseite und der Rückseitenmetallisierung (G) ausgebildet sind, wobei die zweite Metallisierung dem Gate dieser Thyristoren entspricht; sowie
eine erste Lawinendiode (z1) einer ersten Polarität zwischen der zweiten Metallisierung und der Rückseitenmetallisierung (G) und eine zweite Lawinendiode (z2) umgekehrter Polarisierung zwischen einer von den ersten und zweiten Metallisierungen und der Rückseitenmetallisierung (G), wobei diese ersten und zweiten Dioden so angeordnet sind, daß der Übergang einer von ihnen in den leitenden Zustand die Einschaltung eines der Thyristoren in den leitenden Zustand hervorruft.

5. Monolithisches Schutzbauteil nach Anspruch 4, welches umfaßt:
ein Substrat (N) vom ersten Leitfähigkeitstyp;
einen in der Ober- bzw. Vorderseite des Substrats ausgebildeten ersten Bereich (P1) vom zweiten Leitfähigkeitstyp;
einen in der Unter- bzw. Rückseite des Substrats ausgebildeten zweiten Bereich (P2) vom zweiten Leitfähigkeitstyp;
einen im wesentlichen in der halben Oberfläche des ersten Bereichs (P1) ausgebildeten dritten Bereich (N1) vom ersten Leitfähigkeitstyp;
einen im wesentlichen in der halben Oberfläche des zweiten Bereichs (P2) ausgebildeten und zu dem dritten Bereich (N1) im wesentlichen komplementären vierten Bereich (N2) vom ersten Leitfähigkeitstyp;
einen in einem Teil des ersten Bereichs (P1) über einem Teil des vierten Bereichs ausgebildeten fünften Bereich (N3) vom ersten Leitfähigkeitstyp;
einen an der Grenzfläche zwischen dem ersten Bereich (P1) und dem Substrat ausgebildeten sechsten Bereich (N4) vom ersten Leitfähigkeitstyp mit hohem Dotierungspegel;
einen an der Grenzfläche zwischen dem zweiten Bereich (P2) und dem Substrat (N) in Ausrichtung mit wenigstens einem Teil des vierten Bereichs (N2) ausgebildeten siebenten Bereich (N5) vom ersten Leitfähigkeitstyp mit hohem Dotierungspegel;
eine den dritten Bereich (N1) und den größeren Teil des ersten Bereichs (P1) überdeckende erste Metallisierung (M1);
eine einen Teil des ersten Bereichs (P1) benachbart dem dritten Bereich und den fünften Bereich (N3) überdeckende zweite Metallisierung (M3, M4); sowie
eine den zweiten Bereich (P2) und den vierten Bereich (N2) überdeckende dritte Metallisierung.

## Claims

1. A monolithic component for protecting a SLIC **characterized in that** it includes, in an N-type substrate, whose bottom surface is coated with a first uniform metallization (G), a first and a second portions separated by a P-type isolation wall, in which:
the first portion (24) includes two vertical diodes having a common cathode corresponding to the bottom surface of the substrate, two vertical transistors having a common collector and a common base, the collectors corresponding to the bottom surface of the substrate, and
the second portion (23) includes two sets each including a pair of head-to-tail parallel-connected vertical thyristors and a pair of head-to-tail parallel-connected vertical zener diodes for controlling the conduction of said thyristors.

2. The component of claim 1, **characterized in that** the first portion includes:
- a low-doped N-type semiconductor substrate whose bottom surface includes a highly doped layer (N6) coated with a first metallization (G);
- on the side of the upper surface of the substrate, first and second highly-doped P-type wells (P3);
- a third low-doped P-type well (P4) in which are formed first and second N-type regions (N7) and a P-type region (P5);
- a second metallization (M6) connecting the first well to the first N-type region;
- a third metallization connecting the second well to the second N-type region, and
- a fourth (M7) metallization covering the P-type region (P5).

3. The component of claim 2, **characterized in that** each well is surrounded by an N-type ring.

4. The component of claim 1, **characterized in that** the second portion (24) includes:
first and second upper surface metallizations (M1, M3-M4) designed to be connected to the terminals (A, B) of a resistor (Rd);
first and second thyristors (Th1, Th2) head-to-tail parallel-connected between the first metallization of the upper surface and the rear face metallization (G) the second metallization corresponding to the gate of said thyristors; and
a first avalanche diode (z1) having a first polarity between the second metallization and the rear face metallization (G), and a second avalanche diode (z2) having a reverse polarity between one of the first and second metallizations and the rear face metallization (G), said first and second diodes being disposed so that the conduction of one of them causes the conduction of one of the thyristors.

5. The protection monolithic component of claim 4, including:
a substrate of a first conductivity type (N);
a first region of the second conductivity type (P1) formed in the upper surface of the substrate;
a second region of the second conductivity type (P2) formed in the lower surface of the substrate;
a third region of the first conductivity type (N1) formed substantially in one half of the surface of the first region (P1);
a fourth region of the first conductivity type (N2) formed substantially in one half of the surface of the second region (P2) and substantially complementing the third region (N1) ;
a fifth region of the first conductivity type (N3) formed in a portion of the first region (P1) over a portion of the fourth region;
a sixth highly-doped region of the first conductivity type (N4) formed at the interface between the first region (P1) and the substrate;
a seventh highly-doped region of the first conductivity type (N5) formed at the interface between the second region (P2) and the substrate (N) facing at least one portion of the fourth region (N2);
a first metallization (M1) coating the third region (N1) and practically all the first region (P1);
a second metallization (M3, M4) coating a portion of the first region (P1) near the third and the fifth regions (N3) ; and
a third metallization coating the second (P2) and fourth (N2) regions.
